# EUROPEAN PATENT APPLICATION

(11) **EP 4 641 636 A1**
(43) Date of publication of application: **29.10.2025**
(21) Application number: 25172258.3
(22) Date of filing: 24.04.2025
(51) Int. Cl.: H01L 23/538

(54) **DIE-TO-DIE LINKS USING SUBSTRATE AND METHOD OF MAKING**

(30) Priority: 25.04.2024 US 202418646337
(71) Applicant: Avago Technologies International Sales Pte. Limited, Singapore 768923 (SG)
(72) Inventor: Wang, Tao, San Jose, 95134 (US)
(74) Representative: Dilg, Haeusler, Schindelmann Patentanwaltsgesellschaft mbH

(57) **Abstract**

Novel tools and techniques are provided for implementing a semiconductor package or a chip package, and more particularly methods, systems, and apparatuses are provided for implementing a semiconductor package or a chip package including two or more high-density layers for die-to-die interconnections. In various embodiments, a semiconductor device (100) includes a substrate comprising two or more first layers (200) and a second layer (112). A first length (L1) of the two or more first layers (200) can be less than a second length (L2) of the second layer (112). The semiconductor device (100) can further include a first die (104a) coupled to the second layer (112) of the substrate and a second die (104b) coupled to the second layer (112). At least one of the two or more first layers (200) comprises a connector (202) coupling the first die (104a) to the second die (104b).

## Description

### COPYRIGHT STATEMENT

A portion of the disclosure of this patent document contains material that is subject to copyright protection. The copyright owner has no objection to the facsimile reproduction by anyone of the patent document or the patent disclosure as it appears in the Patent and Trademark Office patent file or records, but otherwise reserves all copyright rights whatsoever.

### FIELD

The present disclosure relates, in general, to methods, systems, and apparatuses for implementing a semiconductor package or a chip package.

### BACKGROUND

In existing semiconductor devices, die-to-die links can be implemented using an interposer, interconnect bridge, or the like coupled to a packaging substrate. Each of these die-to-die links are typically implemented external and separate from the packaging substrate. In other words, each of these die-to-die links are manufactured separately from the packaging substrate and coupled to the packaging substrate at a later time in the manufacturing process of the semiconductor device.

Hence, there is a need for more robust and scalable solutions for implementing semiconductor packages and chip packages. Thus, methods, systems, and apparatuses are provided for implementing semiconductor packages or chip packages comprising a substrate having integrated die-to-die links.

### BRIEF DESCRIPTION OF THE DRAWINGS

A further understanding of the nature and advantages of particular embodiments may be realized by reference to the remaining portions of the specification and the drawings, in which like reference numerals are used to refer to similar components. In some instances, a sub-label is associated with a reference numeral to denote one of multiple similar components. When reference is made to a reference numeral without specification to an existing sub-label, it is intended to refer to all such multiple similar components.
FIG. 1 is a schematic top view of a semiconductor device, in accordance with various embodiments;
FIG. 2 is a schematic cross-sectional view of the semiconductor device taken along line A-A of FIG. 1, in accordance with various embodiments;
FIG. 3A is a partial schematic cross-sectional view of the semiconductor device FIG. 2 contained within dashed area B, in accordance with various embodiments;
FIG. 3B is a partial schematic cross-sectional view of the area B of the semiconductor device FIG. 2 contained within dashed area B comprising one or more lines to differentiate the different layers of the substrate, in accordance with various embodiments;
FIG. 4 is a partial schematic cross-sectional view of the semiconductor device of FIG. 3B contained within dashed area C, in accordance with various embodiments; and
FIG. 5 is a flow diagram of a method of fabricating a semiconductor device, in accordance with various embodiments.

### DETAILED DESCRIPTION OF EMBODIMENTS

Various embodiments provide tools and techniques for implementing semiconductor packages or chip packages including a substrate comprising integrated die-to-die links are described herein.

In a first aspect, a semiconductor device can include a substrate comprising two or more first layers and a second layer. The two or more first layers can be at least partially contained within the second layer and a first length of the two or more first layers can be less than a second length of the second layer. The semiconductor device can further include a first die coupled to the second layer of the substrate and a second die coupled to the second layer. In various cases, at least one of the two or more first layers comprises a connector coupling the first die to the second die.

In some cases, the first die and the second die can be coupled to a surface of the second layer and the first die can be located adjacent to the second die. The second layer can be an outermost layer of the substrate.

In some embodiments, the connector comprises at least one of an interconnect or a via.

In various instances, a first thickness of the two or more first layers is about a same thickness as a second thickness of the second layer.

In various cases, the first die can be located adjacent to the second die and a first length of the two or more first layers is less than a third length of the first die and the second die.

In various embodiments, the first die is located adjacent to the second die and a first wall of the two or more first layers can be located toward a first edge of the first die and a second wall of the two of more first layers can be located toward a second edge of the second die.

In some embodiments, the first die is located adjacent to the second die and a first portion of the two or more first layers can at least partially extend under a first edge of the first die and a second portion of the two or more first layers can at least partially extend under a second edge of the second die. The first portion of the two or more first layers extending under the first edge of the first die may not extend past a first center of the first die and the second portion of the two or more first layers extending under the second edge of the second die may not not extend past a second center of the second die.

In various instances, the two or more first layers comprise a first number (N) of conducting layers and a second number (N+1) of dielectric layers. In various cases, the dielectric layers alternate with the conducting layers. A second thickness of the second layer can be about equal to the first number of the conducting layers multiplied by a third thickness of the conducting layers plus the second number of the dielectric layers multiplied by a fourth thickness of the dielectric layers. In some cases, a third thickness of a conducting layer is between about a second thickness of the second layer divided by sixteen and about the second thickness of the second layer divided by eight and a fourth thickness of the dielectric layer is between about the second thickness of the second layer multiplied by five and divided by thirty-two and about the second thickness of the second layer multiplied by thirteen and divided by sixty-four. In some instances, the two or more first layers comprise at least three conducting layers and at least four dielectric layers. The at least three conducting layers can comprise a return ground layer and two routing layers.

In another aspect, a method of manufacturing a substrate of a semiconductor device can include forming a portion of a first substrate, forming two or more first layers on a surface of the portion of the first substrate, and forming a second layer on the portion of the first substrate and surrounding the two or more first layers. In some cases, the two or more first layers comprise a connector configured to couple a first die to a second die. In various instances, a first length of the two or more first layers is less than a second length of the second layer.

In some embodiments, forming the two or more first layers comprises forming a first dielectric layer on the surface of the portion of the first substrate, forming a conducting layer on the first dielectric layer, and forming a second dielectric layer on the conducting layer. In some cases, forming the first dielectric layer on the surface of the portion of the first substrate further comprises forming a first via in the first dielectric layer, forming the conducting layer on the first dielectric layer comprises forming an interconnect and coupling the interconnect to the first via, and forming the second dielectric layer comprises forming a second via in the first dielectric layer and coupling the second via to the interconnect.

In various instances, forming two or more first layers on a surface of the portion of the first substrate comprises forming the two or more first layers only in one or more die-to-die link areas of the substrate.

The method can further include coupling a first die to the connector and coupling a second die to the connector.

In yet another aspect, a substrate can include two or more first layers comprising a connector configured to couple a first die to a second die and a second layer. In some cases, the two or more first layers are at least partially surrounded by the second layer and a first length of the two or more first layers is less than a second length of the second layer.

In some instances, a first thickness of the two or more first layers is about a same thickness as a second thickness of the second layer.

In the following description, for the purposes of explanation, numerous details are set forth to provide a thorough understanding of the described embodiments. It will be apparent to one skilled in the art, however, that other embodiments may be practiced without some of these details. Several embodiments are described herein, and while various features are ascribed to different embodiments, it should be appreciated that the features described with respect to one embodiment may be incorporated with other embodiments as well. By the same token, however, no single feature or features of any described embodiment should be considered essential to every embodiment of the invention, as other embodiments of the invention may omit such features.

When an element is referred to herein as being "connected," "coupled," or "attached" to another element (such as coupled or connected through an electrical or communicative connection or coupled or attached through a mechanical connection or attachment), it is to be understood that the elements can be directly connected to the other element, or have intervening elements present between the elements. In contrast, when an element is referred to as being "directly connected," "directly coupled," or "directly attached" to another element, it should be understood that no intervening elements are present in the "direct" connection between the elements. However, the existence of a direct connection does not exclude other connections, in which intervening elements may be present.

When an element is referred to herein as being "disposed" or "located" in some manner relative to another element (e.g., disposed on, disposed between, disposed under, disposed adjacent to, or disposed in some other relative manner), it is to be understood that the elements can be directly disposed or located relative to the other element (e.g., disposed directly on another element), or have intervening elements present between the elements. In contrast, when an element is referred to as being "disposed directly" or "located directly" relative to another element, it should be understood that no intervening elements are present in the "direct" example. However, the existence of a direct disposition does not exclude other examples in which intervening elements may be present.

Likewise, when an element is referred to herein as being a "layer," it is to be understood that the layer can be a single layer or include multiple layers. For example, a conductive layer may comprise multiple different conductive materials, multiple layers of different conductive materials, or dielectric layers comprising conductive material or one or more layers of conductive material, and a dielectric layer may comprise multiple dielectric materials, multiple layers of dielectric materials, or conductive material or one or more layers of conductive material at least partially surrounded by dielectric materials or one or more dielectric layers. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Additionally, when an element is referred to herein as being a "circuit," or "die," it is commonly recognized as a building block of modern electronics. The circuit or die could be an electronic circuit, and electronic integrated circuit, a photonic circuit, a photonic integrated circuit, or other type of circuit or die. Circuits of dies can be composed of various components such as resistors, capacitors, inductors, diodes, transistors, integrated circuits, optical components (e.g., lenses, optical sources, fibers, or the like), or the like. In some cases, integrated circuits can be formed from one or more circuits. These components are carefully selected and interconnected to create a circuit or die that can perform a specific task or carry out a particular function. Circuits or dies can be as simple as a basic switch that turns a light on and off, or they can be incredibly complex, such as those found in advanced computer systems, communication devices, or medical equipment. Circuits or dies can be categorized into different types based on their purpose or function, including amplifiers, oscillators, filters, power supplies, logic gates, photonic transceivers, among others. Additionally, circuits or dies can include software or firmware in addition to hardware or instead of hardware to carry out a particular function.

Moreover, the terms left, right, front, back, top, bottom, forward, reverse, under, over, clockwise and counterclockwise are used for purposes of explanation only and are not limited to any fixed direction or orientation. Rather, they are used merely to indicate relative locations and/or directions between various parts of an object and/or components. Additionally, terms such as first, second, third, are merely used to distinguish elements or components from each other and are not intended to imply an order or sequence unless expressly stated otherwise.

Furthermore, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." The term "substantially" or "about" used herein refers to variations from the reference value or ratio of ± 20% or less (e.g., ± 20%, ± 10%, ± 5%, etc.), inclusive of the endpoints of the range.

In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of" preceding a series of items, with the term "and" or "or" to separate any of the items, modifies the list as a whole, rather than each member of the list (i.e., each item). The phrase "at least one of" does not require selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

In existing semiconductor or chip packages, die-to-die links are typically formed external and separate to a packaging substrate. In a non-limiting example, die-to-die links can be implemented using an interposer, interconnect bridge, or the like coupled to the packaging substrate. Each of the die-to-die links described above are formed external to and separate from the packaging substrate and coupled to the packaging substrate after the packaging substrate has been formed. These die-to-die links also typically span the entire length of the substrate taking up valuable space on the substrate.

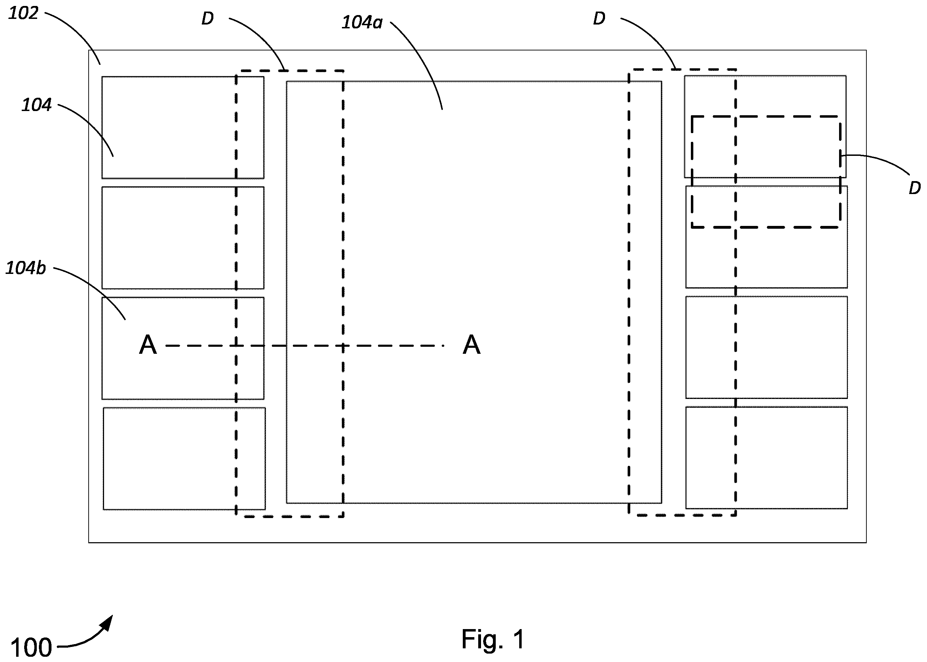

The subject technology comprises a semiconductor or chip device (e.g., integrated circuit (IC), chip, or other semiconductor device or module) that provides a packaging substrate comprising one or more integrated layers having one or more die-to-die links. By implementing the packaging substrate having one or more integrated layers comprising die-to-die links, several advantages can be realized. For example, die-to-die links can be formed in only in areas of the packaging substrate where they are needed and do not need to span across a significant area of the substrate. Further, integrating the die-to-die links within the packaging substrate helps account for die-to-die offset variations, die-to-die spacing variations, die-to-die routing variations, or the like. For example, because there are no external or separate die-to-die links that need to be coupled to the substrate after the substrate is formed, one or more dies can be directly coupled to the packaging substrate without the need to account for variations that can be caused using an external die-to-die link such as an interposer, interconnect bridge, or the like. These and other advantages of the subject technology are discussed below with respect to FIGS. 1-5.

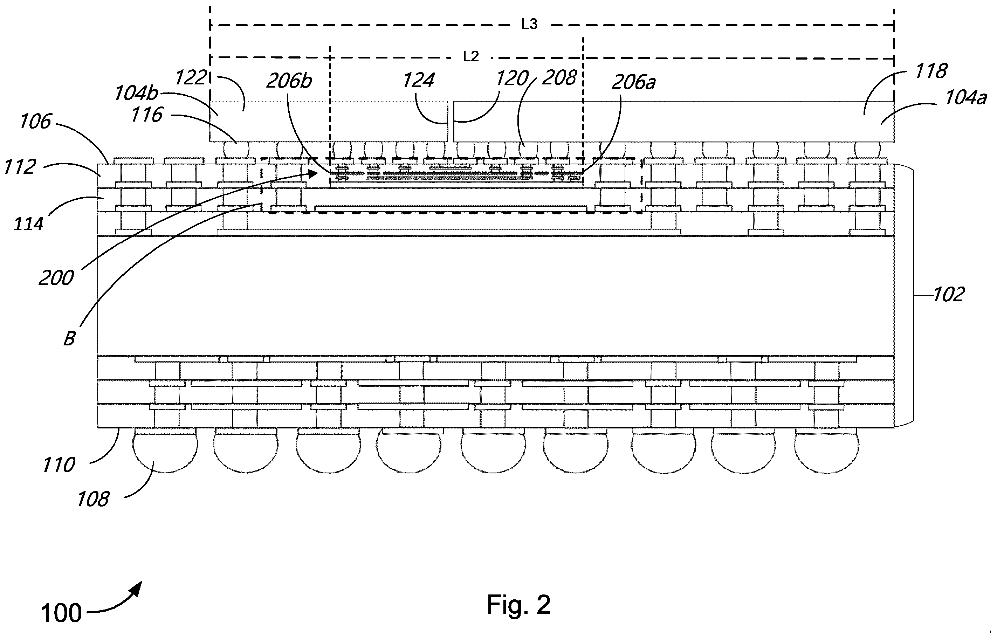

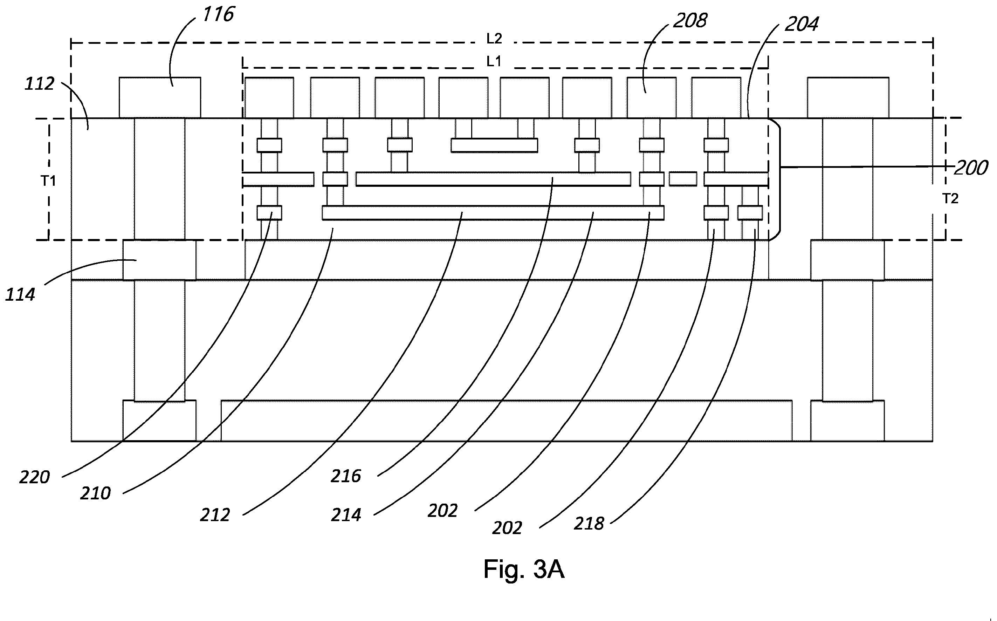

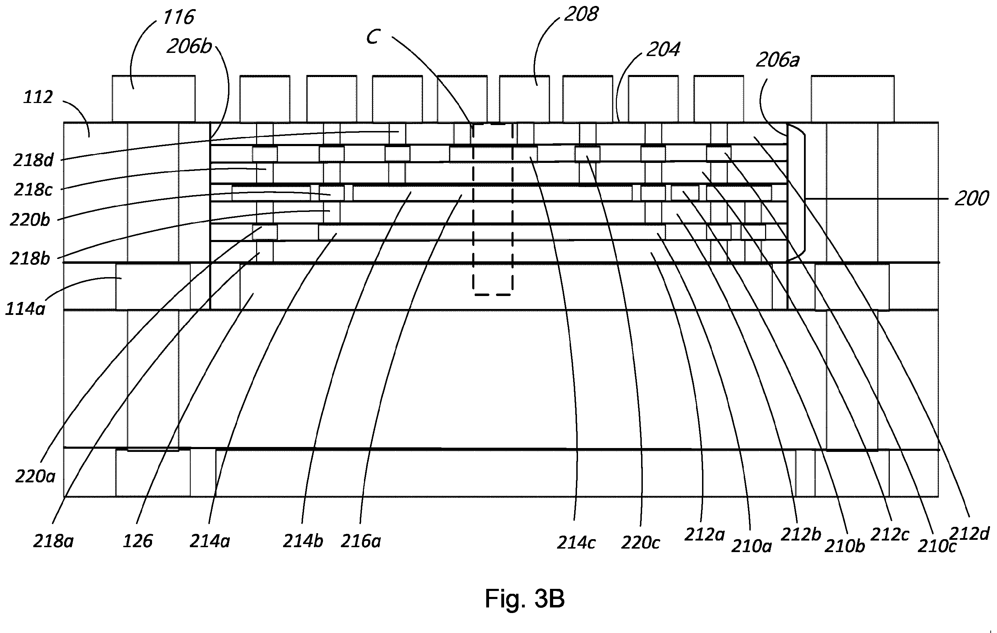

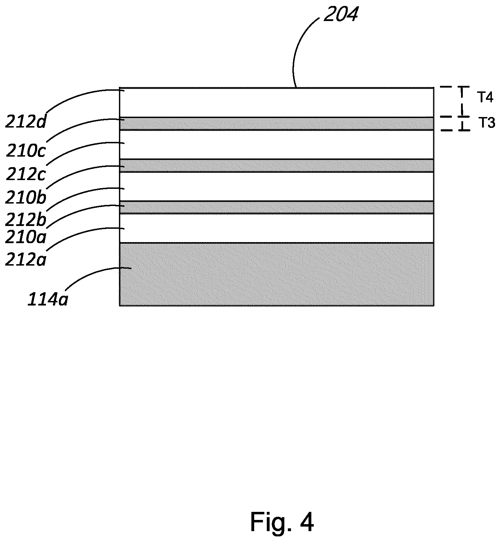

FIGS. 1-4 are schematic views of different embodiments of a semiconductor device 100, in accordance with various embodiments. FIG. 1 is a top view of the semiconductor device 100 while FIG. 2 is a partial cross-sectional view of the semiconductor device of FIG. 1 taken along axis A-A of FIG. 1. FIG. 3A is a partial cross-sectional view of the semiconductor device of FIG. 2 contained within dashed area B. FIG. 3B is a partial cross-sectional view of the semiconductor device of FIG. 2 contained within dashed area B comprising one or more lines to differentiate the different layers of the substrate 102. FIG. 4 is a partial cross-sectional view of the semiconductor device of FIG. 3 contained within dashed area C.

It should be noted that the various components of semiconductor device 100 are schematically illustrated in FIGS. 1-4, and that modifications to the various components, orientations, and other arrangements of semiconductor device 100 may be possible and in accordance with the various embodiments. In addition, only some components and/or layers of the semiconductor device 100 are shown in FIGS. 1-4, there could be more or less components and/or layers, in accordance with various embodiments and semiconductor device 100 is not intended to be limited to only the components and/or layers shown.

In various embodiments, the semiconductor device 100 includes a substrate 102. The substrate 102 can be a packaging substrate, a carrier substrate, a support substrate or the like configured to support one or more dies 104 coupled to a first surface 106 of the substrate 102. As an example, the term "package," "carrier," or "support" refers to one or more materials or one or more layers that hold, support, protect, or provide structural or mechanical rigidity to the one or more dies 104 within the semiconductor device 100. There are different types of packaging, carrier, or support substrates depending on the packaging technology and application. For example, a substrate 102 according to embodiments of the present disclosure may include one or more materials such as silicon (e.g., monocrystalline silicon, polycrystalline silicon, or the like), gallium arsenide, sapphire, silicon carbide, glass material, organic material, ceramic material, and/or other material or combination of materials configured to carry or support the one or mor dies 104.

Depending on the particular application, carriers or support substrates can possess attributes such as heat dissipation capabilities, or other features. For example, the substrate 102 can be engineered to provide structural and mechanical rigidity and support for the one or more dies 104 within a packaging of the semiconductor device 100. In some cases, the substrate 102 can be an "active" substrate (e.g., a substrate comprising one or more active devices) or the substrate 102 can be a "passive" substrate (e.g., a substrate comprising one or more passive devices). In various cases, the one or more active devices can include, without limitation, one or more components or connections (e.g., transistors, memory devices, or the like) that can control the flow of power. The one or more passive devices can include, without limitation, one or more components or connections (e.g., conductors, resistors, capacitors, inductors, connections, connectors, interconnects, vias, etc.) which can transmit, absorb, and/or dissipate power. In various cases, the substrate 102 can contain both active and passive devices or connections.

In some instances, the substrate 102 can be formed from one or more layers. The one or more layers can include, without limitation, one or more dielectric layers, one or more device (e.g., active or passive device or the like) or circuit layers, one or more conducting layers, one or more insulating layers, one or more redistribution layers, and/or the like.

In various cases, the substrate 102 can be coupled to a circuit board, a land grid array, another substrate, or another component of the semiconductor device 100. One or more solder balls, solder bumps, posts, pillars, or pads 108 can be coupled to a second surface 110 (e.g., an outer surface or the like) of the substrate 102 to couple the substrate 102 to the circuit board, LGA, another substrate, or another component of the semiconductor device 100.

In some embodiments, one or more dies or circuits 104 can be coupled to the first surface 106 (e.g., an outer surface or the like) of the substrate 102. In a non-limiting example, the one or more dies 104 can include one or more electronic dies, electronic circuits, electronic integrated circuits (EICs), one or more photonic dies, photonic circuits, or photonic integrated circuits (PICs), or the like. As shown in FIGS. 1 and 2, the one or more dies or circuits include a first die 104a and a second die 104b. However, more dies (as shown in FIG. 1) or less dies are and within the scope of this disclosure.

The one or more dies 104 can include one or more active devices or components or passive devices or components. In some cases, the one or more dies 104 can include one or more layers (not shown). The one or more layers can include, without limitation, one or more dielectric layers, one or more device or circuit layers, one or more conducting layers, one or more insulating layers, one or more redistribution layers, other layers, and/or the like. In some instances, the one or more dies can be formed from one or more of silicon, silicon germanium, silicon nitride, indium phosphide, silicon on insulator (SOI), or other material or combination of materials.

In some embodiments, the one or more dies 104 can include one or more processing units (e.g., a central processing unit or the like), one or more switch application specific integrated circuits (ASICs), one or more controlling circuits or switch circuits, one or more photonic circuits, one or more memory circuits, other circuits, or the like. In some cases, in a non-limiting example, the first die 104a could be a processing unit or ASIC while the second die 104b could be a switch circuit, photonic circuit, or memory circuit. In some cases, the first die 104a can be configured to control one or more operations or functions of the second die 104b or other dies coupled to the substrate 102. In some cases, the second die 104b can be located directly or indirectly adjacent to or directly or indirectly next to the first die 104a on the surface 106 of the substrate 102. Other die configurations are also possible and within the scope of this disclosure.

In various instances, the first die 104a can be communicatively coupled or electrically coupled to the second die 104b. In order to communicatively couple or electrically couple the first die 104a to the second die 104b, two or more first layers 200 can be integrated within or contained within a second layer 112 of the substrate 102 and configured to provide one or more connectors 202 coupling the first die 104a to the second die 104b. The one or more connectors 202 can provide one or more die-to-die links between the first die 104a and the second die 104b and communicatively couple or provide one or more signal connections, ground connections, or the like between the first die 104a and the second die 104b.

In some embodiments, the two or more first layers 200 can be one or more high-density layers (e.g., high-density routing layers, high-density interconnection layers, high-density dielectric layers, or combinations of layers, or the like) of the substrate 102. The one or more high-density layers can comprise one or more blind or buried vias and one or more interconnects to provide electrical connections between dies in a selected area of the substrate 102. For example, as shown in FIG. 1, dashed areas D indicates potential locations where the two or more second layers can be integrated within substrate 102. In various cases, as discussed above and below, the one or more high-density layers can be integrated within the second layer 112 of the substrate 102.

In various cases, the second layer 112 of the substrate 102 can be coupled to one or more additional or other layers 114 of the substrate 102 and can be an outer layer (e.g., a layer located toward or near the surface 106 of the substrate) of the substrate 102. In some cases, the second layer 112 can be an outermost layer (e.g., a layer comprising the external surface 106 of the substrate 102, an outermost silicon layer of the substrate, an outer layer directly coupled to one or more solder bump or pads 116, or the like). In some cases, the second layer 112 can be a single (e.g., only one) layer or multiple (e.g., two or more) layers surrounding (e.g., fully surrounding or fully encapsulating the two or more first layers 200, at least partially surrounding or at least partially encapsulating the two or more first layers 200, or the like). In a non-limiting example, the second layer 112 could be a single dielectric layer or a single insulating layer comprising or containing the two or more first layers 200.

In some instances, the second layer 112 can fully contain, surround, or encapsulate the two or more first layers 200. In other embodiments, as shown in FIG. 3B, the second layer 112 can at least partially contain, at least partially surround, or fully surround one or more walls or sides 206 of the two or more first layers 200 while keeping a surface 204 (e.g., an outer surface or the like) of the two or more first layers 200 exposed. The surface 106 of the second layer 112 can be configured to couple (e.g., directly or indirectly couple) to one or more first solder bumps or pads 116 while the outer surface 204 of the two or more first layers 200 can be configured to couple (e.g., directly or indirectly couple) to one or more second solder bumps or pads 208. In some cases, the one or more first solder bumps or pads 116 or the one or more second solder bumps or pads 208 could include or instead be one or more return planes or the like. The one or more first or second solder bumps or pads 116 and 208 can include, without limitation, one or more solder bumps, one or more via pads, or one or more other connections configured to couple the one or more dies 104 to the substrate 102.

In some embodiments, as shown in FIG. 3A, a first thickness (T1) of the two or more first layers 200 can be a same or about a same thickness as a second thickness (T2) of the second layer 112 of the substrate 102. In a non-limiting example, the first thickness (T1) of the two or more first layers 200 combined can be the same or about the same thickness as the second thickness (T2) of the single second layer 112 of the substrate 102. In some cases, a first length (L1), first width, or first area of the two or more first layers 200 can be less than a second length (L2), second width, or second area of the second layer 112. Because the first length (L1), first width, or first area of the two or more first layers 200 is less than the second length (L2), second width, or second area of the second layer 112, the two or more first layers 200 can be placed in the substrate 102 at locations where die-to-die links or connections are needed and do not need to expand over the entire length, width, or area of the substrate 102. For example, as shown in FIG. 1, dashed areas D indicate potential locations or areas (e.g., die-to-die link areas or the like) where the two or more second layers can be integrated within substrate 102 to provide die-to-die links or connections.

Additionally or alternatively, in some cases, the first length (L1), first width, or first area of the two or more first layers 200 can be less than a third length (L3), third width, or third area of the first die 104a and the second die 104b when the first die 104a is located adjacent to the second die 104b as shown in FIG. 2. In some cases, a first wall 206a of the two or more first layers 200 can be located toward (e.g., in a location between a first center portion 118 or approximately a center portion 118 of the first die 104a and a first edge 120 closest to the second die 104b) a first edge 120 of the first die 104a while a second wall 206b of the two or more first layers 200 can be located toward (e.g., in a location between a second center portion 122 or approximately a center portion 122 of the second die 104b and a second edge 124 closest to the first die 104a). In other words, the two or more first layers 200 can be located mostly between the first die 104a and the second die 104b in locations where one or more die-to-die links are needed.

In other cases, a first portion of the two or more first layers 200 can at least partially extend under the first edge 120 of the first die 104a and a second portion of the two or more first layers 200 can at least partially extend under a second edge 124 of the second die 104b. In some instances, the first portion of the two or more first layers 200 extending under the first edge 120 of the first die 104a does not extend past a first center portion 118 or approximately a first center portion 118 of the first die 104a and the second portion of the two or more first layers 200 extending under the second edge 124 of the second die 104b does not extend past a second center portion 122 or approximately a second center portion 122 of the second die 104b.

In various cases, the two or more first layers 200 can include one or more conductor or conductive layers 210 or one or more dielectric or insulator layers 212. The one or more conductor layers 210 can include one or more connectors 202 configured to couple the first die 104a to the second die 104b. In some cases, the one or more conductor layers 210 can further include a dielectric material or layer to embed the one or more connectors 202. The one or more dielectric layers 212 can include one or more connectors 202 (such as one or more vias, or the like) configured to couple the first die 104a to the second die 104b. In some cases, the one or more connectors 202 of the one or more conductor layers 210 can be coupled to the one or more connectors 202 of the dielectric layer 212 to couple the first die 104a to the second die 104b.

As shown in FIG. 3A, the one or more connectors 202 can include, without limitation, one or more interconnects 214 (e.g., traces, wires, or the like), conductive grounding interconnects or planes 216, conductive vias 218, conductive pads 220 (e.g., via pads or the like), and/or other suitable connectors configured to conduct a voltage, an electrical signal, power, or the like. The one or more vias 218 may extend through the two or more first layers 200 from one outer surface 204 (e.g., a "blind" via), or may extend through a portion of the two or more first layers 200 and be completely hidden from external view (e.g., a "buried" via), and/or the like. In some cases, the one or more vias 218 can be one or more micro vias, or the like. The conductive material of the one or more connectors 202 might include a metal such as copper, titanium, tungsten, aluminum, gold, silver, tin, nickel, lead, or a combination of metals/alloys, or may be formed of other electrically conductive material or combination of electrically conductive materials.

In various cases, the one or more conductor layers 210 and the one or more dielectric layers 212 can alternate with each other within the second layer 112. In some cases, the one or more dielectric layers 212 can be used to surround (e.g., at least partially surround or fully surround) or encapsulate (e.g., at least partially encapsulate or fully encapsulate) the one or more conductor layers 210. In some cases, the two or more first layers 200 comprise a first number (N) of conducting layers 210 and a second number (N+1) of dielectric layers 212. In other words, there is one more dielectric layer than conducting layer (e.g., if there are three (N) conducting layers, then there can be four (N+1) dielectric layers) contained within the second layer 112 of the substrate 102.

In some instances, the second thickness (T2) of the second layer 112 is about equal to a combined thickness of a thickness of the conductor layers 210 plus a thickness of the dielectric layers. In some instances, each of the conductor layers 210 have about a same thickness (T3) while each of the dielectric layers 212 have about a same thickness (T4). In this non-limiting example, the second thickness (T2) of the second layer 112 is about equal to the first number (N) of the conducting layers 210 multiplied by a third thickness (T3) of the conducting layers plus the second number (N+1) of the dielectric layers 212 multiplied by a fourth thickness (T4) of the dielectric layers 212.

In some embodiments, the third thickness (T3) of at least one conducting layer 210 is between about a second thickness (T2) of the second layer 112 divided by sixteen and about the second thickness (T2) of the second layer 112 divided by eight. In some cases, a fourth thickness (T4) of at least one dielectric layer 212 is between about the second thickness (T2) of the second layer 112 multiplied by five and divided by thirty-two and about the second thickness (T2) of the second layer 112 multiplied by thirteen and divided by sixty-four. In a non-limiting example, the third thickness (T3) of at least one conducting layer 210 is approximately 4 micrometers (µm) while the fourth thickness (T4) of the at least one dielectric layer is about 9.5 µm. Thus, when there are three conducting layers and four dielectric layers, the second thickness (T2) of the second layer 112 can be about 50 µm. These thicknesses of the dielectric and conductor layers is advantageous because it allows for both routing layers and grounding layers to be contained within the two or more layers as described in the non-limiting example below.

In the non-limiting examples shown in FIGS. 2-4, there are at least three conducting layers 210a-c and at least four dielectric layers 212a-d. The first dielectric layer 212a can be coupled to one or more additional layers 114 of the substrate 102. In some cases, the first dielectric layer 212a can be configured to surround (e.g., at least partially or fully) a first additional layer 114a or a conductive element (e.g., via pad, plane or interconnect, or other conductive element, the like) of the first additional layer 114a. In some cases, the first dielectric layer 212a can be deposited on top of another dielectric layer surrounding a conductive element of the first additional layer 114a. Turning to FIG. 3B, the first additional layer 114a of the one or more additional layers 114 could be a conducting layer or a grounding layer (e.g., a return ground layer or the like) comprising one or more interconnects or planes 126 configured to return a voltage to ground. In various cases, the first dielectric layer 212a can include one or more connectors 202 comprising one or more first vias 218a configured to couple the first die 104a or the second die 104b to one or more grounding interconnects or planes 126 of the first additional layer 114a.

Next, a first conducting layer 210a can be coupled to the first dielectric layer 212a. The first conducting layer 210a could be a routing layer such as a stripline routing layer (e.g., a transmission layer located between two grounding layers (e.g., first additional layer 110a and second conducting layer 210b)). The first conducting layer 210a could include one or more connectors 202 comprising one or more first interconnects 214a configured to route (e.g., transmit, receive, or the like) one or more signals from or to the first die 104a to or from the second die 104b. In some cases, the first conducting layer 210a or one or more first interconnects 214a could be configured to route one or more high-speed signals, one or more DC signals, one or more high-frequency signals, or the like. In some cases, the first conducting layer 210a can further include one or more first via pads 220a or other connectors 202 configured to couple to the one or more first vias 218a of the first dielectric layer 212a or one or more second vias 218b of the second dielectric layer 212b.

Additionally, in the embodiment shown in FIGS. 2-4, a second dielectric layer 212b could be coupled to, deposited on, encapsulate, or the like the first conducting layer 210a comprising the one or more first interconnects 214a. In some cases, the second dielectric layer 212b can be deposited on top of another dielectric layer surrounding the one or more first interconnects 214a. The second dielectric layer 212b could include one or more connectors 202 comprising one or more second vias 218b configured to couple one or more connectors 202 of the first conductive layer 210a to one or more connectors 202 of a second conductive layer 210b.

The second conducting layer 210b can be coupled to the second dielectric layer 212b. The second conducting layer 210b could be a grounding layer (e.g., a return ground layer or the like). The second conducting layer 210b could include one or more connectors 202 comprising one or more second interconnects 214b or one or more first grounding planes 216a configured to return a voltage to ground. The one or more third interconnects 214c or the one or more first grounding planes 216a can be coupled to the one or more second vias 218b or the grounding plane 126. The second conducting layer 210b can further include one or more second via pads 220b or other connectors 202 configured to couple to the one or more second vias 218b, one or more third vias 218c, or other connectors 202 of the two or more first layers 200.

Next, in the embodiment shown in FIGS. 2-4, a third dielectric layer 212c can be coupled to, deposited on, encapsulate, or the like the second conducting layer 210b comprising the one or more second interconnects 214b or the one or more first grounding planes 216a. In some cases, the third dielectric layer 212c can be deposited on top of another dielectric layer surrounding the one or more second interconnects 214b or the one or more first grounding planes 216a. The third dielectric layer 212c could include one or more connectors 202 comprising one or more third vias 218c configured to couple connectors 202 of the second conductive layer 210b to connectors 202 of the third conductive layer 210c.

A third conducting layer 210c could be coupled to the third dielectric layer 212c. The third conducting layer 210c could be a routing layer such as a stripline routing layer (e.g., a transmission layer located between a grounding layers (e.g., the second conducting layer 210b) and a surface 204 of the substrate 102). The third conducting layer 210c could include one or more connectors 202 comprising one or more third interconnects 214c configured to route one or more signals from or to the first die 104a to or from the second die 104b. In some cases, the third conducting layer 210c or the one or more third interconnects 214c could be configured to route one or more high-speed signals, one or more DC signals, one or more high-frequency signals, or the like. In some cases, the third conducting layer 210c can further include one or more third via pads 220a or other connectors 202 configured to couple to the one or more third vias 218c of the third dielectric layer 212c or one or more fourth vias 218d of the fourth dielectric layer 212d.

Additionally, in the embodiment shown in FIGS. 2-4, a fourth dielectric layer 212d could be coupled to, deposited on, encapsulate, or the like the third conducting layer 210c. In some cases, the fourth dielectric layer 212c can be deposited on top of another dielectric layer surrounding the one or more third interconnects 214c. The fourth dielectric layer 210d can include one or more connectors 202 comprising one or more fourth vias 218d configured to couple connectors 202 of the third conductive layer 210c to one or more via pads 208, solder bumps, or the like located on a surface 204 of the fourth dielectric layer 212d or a surface 106 of the second layer 112. In some cases, one or more grounding layers or fourth conducting layers could also be included on the surface 204 of the fourth dielectric layer 212d or a surface 106 of the second layer 112 to act as grounding plane for the third conducting layer 210c.

Next, the second layer 112 of the substrate can be coupled to the conducting layers 210a-210c and the dielectric layers 212a-212d. In various cases, the second layer 112 of the substrate 102 can fully or at least partially surround or encapsulate the conducting layers 210a-210c and the dielectric layers 212a-212d. Next, one or more of one or more via pads 208, solder bumps, or the like could be coupled to the one or more fourth vias 218d. The one or more via pads 208, solder bumps, or the like could be configured to couple to at least one of the first die 104a or the second die 104b. In this way, the first die 104a can be electrically or communicatively coupled to the second die 104b via the one or more connectors 202 of the two or more first layers 200. The first die 104a and the second die 104b can further be coupled to ground via the one or more connectors 202 of the two or more first layers 200.

As indicated above, FIGS. 2-4 represent one implementation of the two or more first layers 200 and other configurations are possible and within the scope of the disclosure. Additionally, FIGS. 2-4 only represent some possible components or layouts or configurations of the components of the two or more first layers 200 and more or less components or other layouts or configurations are possible and within the scope of this disclosure.

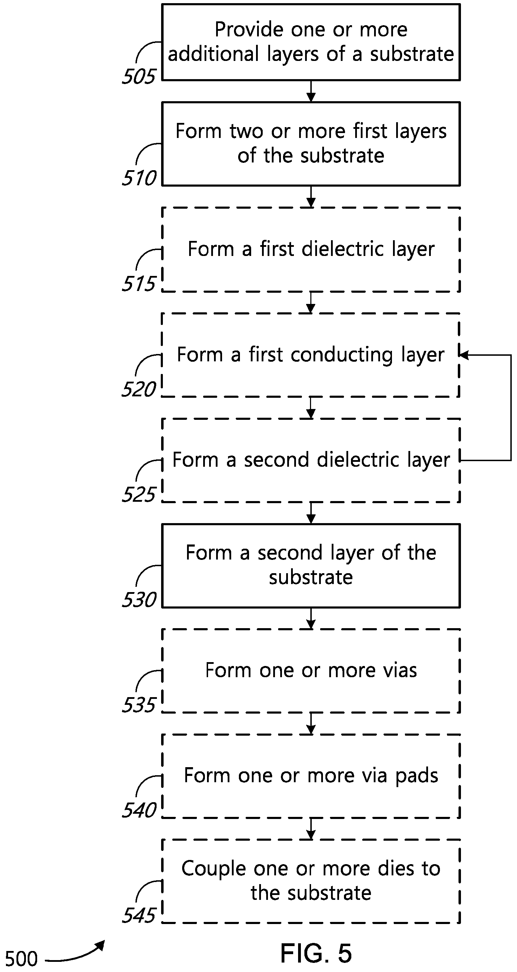

FIG. 5 is a flow diagram of a method of manufacturing a semiconductor device 100, in accordance with various embodiments. The method described in FIG. 5 is one way the components of FIGS. 1-4 can be manufactured. However, other methods may be used to manufacture the components of FIGS. 1-4.

Turning to Fig. 5, the method 500 may begin, at block 505, by providing or forming one or more additional or other layers (e.g., additional or other layers 114, or the like) of a substrate (e.g., substrate 102, or the like). Forming the substrate may include, without limitation, various semi-additive and/or subtractive manufacturing processes, as known to those skilled in the art. In further examples, manufacturing techniques that are being developed and/or yet to be developed may be utilized to form the substrate. Thus, it is to be understood that the method 500 is not limited to any particular method of manufacturing the substrate comprising the one or more additional or other layers.

Next, the method 500 can continue at block 510 by forming or coupling two or more first layers (e.g., two or more first layers 200 or the like) on the one or more additional layers of the substrate. The two or more first layers can be formed only on locations of the one or more additional layers of the substrate where die-to-die links are needed between dies (e.g., two or more dies 104 or the like). Thus, a length, area, or width of the two or more first layers can be less than a length, area, or width of the one or more additional layers of the substrate.

In order to form the two or more first layers, the method 500 can continue to optional block 515 by forming or coupling a first dielectric layer (e.g., first dielectric layer 212a or the like) on the one or more additional layers of the substrate. One or more connectors (e.g., connectors 202 or the like) such as one or more vias can be drilled or formed within the first dielectric layer to couple the one or more dies together, to couple the one or more dies to the one or more additional layers, or to couple the one or more dies to ground, or the like.

Next, the method 500 can continue to optional block 520 and form a first conducting layer (e.g., first conducting layer 210a or the like) on the first dielectric layer 512a. In various cases, one or more connectors (e.g., connectors 202 or the like) can be formed within the first conducting layer to couple the one or more dies together, to couple the one or more dies to the one or more additional layers, or to couple the one or more dies to ground, or the like. In various cases, the first conducting layer can include one or more routing connectors such as interconnects or traces configured to communicatively or electrically couple a first die to a second die or one or more grounding planes configured to couple the first die or the second die to ground. The first conducting layer can be plated and patterned only in selected locations where the first dielectric layer was formed or in selected locations where die-to-die links are needed.

In some cases, the method 500 can then continue to optional block 525 and form or couple a second dielectric layer (e.g., second dielectric layer 212b or the like) to the first conducting layer. One or more connectors (e.g., connectors 202 or the like) such as one or more vias can be drilled or formed within the second dielectric layer, first conducting layer, or first dielectric layer to couple the one or more dies together, to couple the one or more dies to the first conducting layer, to couple the one or more dies to the one or more additional layers, or to couple the one or more dies to ground, or the like. Method steps 520 and 525 can then be repeated until a selected number of the two or more first layers are reached. In the non-limiting example of FIGS. 2-4, method steps 520-525 can be repeated two more times in order to obtain three conducting layers and four dielectric layers.

Next, method 500 can continue to block 530 and form a second layer on the one or more additional layers and the two or more first layers. In a non-limiting example, the second layer can be formed to fully or at least partially surround the one or more additional layers and the two or more first layers. In some cases, a top surface of the two or more first layers can remain as an outer surface while the second layer at least partially surrounds or encapsulates one or more walls of the two or more first layers.

Method 500 can further include, at optional block 535, forming or drilling one or more vias in the second layer of the substrate and the one or more additional layers of the substrate. Next, method 500 can include, at optional block 540, forming or coupling one or more via pads (e.g., via pads 116 or 208 or the like) solder bumps or other connector to a surface of the second layer or the surface of the two or more first layers and, at optional block 545, forming or coupling one or more dies to the one or more via pads, solder bumps, or other connector. The one or more dies can then be coupled to each other using the connectors of the two or more first layers.

The techniques and processes described above with respect to various embodiments may be used to manufacture the semiconductor devices 100 of FIGS. 1-4, and/or components thereof, as described herein. However, other manufacturing processes can be used and are within the scope of this disclosure.

While some features and aspects have been described with respect to the embodiments, one skilled in the art will recognize that numerous modifications are possible. For example, the methods and processes described herein may be implemented using hardware components, custom integrated circuits (ICs), programmable logic, and/or any combination thereof. Further, while various methods and processes described herein may be described with respect to particular structural and/or functional components for ease of description, methods provided by various embodiments are not limited to any particular structural and/or functional architecture but instead can be implemented in any suitable hardware configuration. Similarly, while some functionality is ascribed to one or more system components, unless the context dictates otherwise, this functionality can be distributed among various other system components in accordance with the several embodiments.

Moreover, while the procedures of the methods and processes described herein are described in a particular order for ease of description, unless the context dictates otherwise, various procedures may be reordered, added, and/or omitted in accordance with various embodiments. Moreover, the procedures described with respect to one method or process may be incorporated within other described methods or processes; likewise, system components described according to a particular structural architecture and/or with respect to one system may be organized in alternative structural architectures and/or incorporated within other described systems. Hence, while various embodiments are described with or without some features for ease of description and to illustrate aspects of those embodiments, the various components and/or features described herein with respect to a particular embodiment can be substituted, added and/or subtracted from among other described embodiments, unless the context dictates otherwise. Consequently, although several embodiments are described above, it will be appreciated that the invention is intended to cover all modifications and equivalents within the scope of the following claims.

## Claims

1. A semiconductor device (100) comprising:
a substrate (102) comprising:
two or more first layers (200);
a second layer (112), wherein the two or more first layers (200) are at least partially contained within the second layer (112), and wherein a first length (L1) of the two or more first layers (200) is less than a second length (L2) of the second layer (112);
a first die (104a) coupled to the second layer (112) of the substrate (102); and
a second die (104b) coupled to the second layer (112), wherein at least one of the two or more first layers (200) comprises a connector (202) coupling the first die (104a) to the second die (104b).

2. The substrate (102) of claim 1, wherein the first die (104a) and the second die (104b) are coupled to a surface of the second layer (112) and wherein the first die (104a) is located adjacent to the second die (104b).

3. The substrate (102) of claim 2, wherein the second layer (112) is an outermost layer of the substrate (102).

4. The substrate (102) of any of claims 1 to 3, wherein the connector (202) comprises at least one of an interconnect or a via.

5. The substrate (102) of any of claims 1 to 4, wherein a first thickness of the two or more first layers (200) is about a same thickness as a second thickness of the second layer (112).

6. The substrate (102) of any of claims 1 to 5, wherein the first die (104a) is located adjacent to the second die (104b), wherein a first length (L1) of the two or more first layers (200) is less than a third length of the first die (104a) and the second die (104b).

7. The substrate (102) of any of claims 1 to 6, wherein the first die (104a) is located adjacent to the second die (104b), and wherein a first wall of the two or more first layers (200) is located toward a first edge of the first die (104a) and a second wall of the two of more first layers (200) is located toward a second edge of the second die (104b).

8. The substrate (102) of any of claims 1 to 7, wherein the first die (104a) is located adjacent to the second die (104b), and wherein a first portion of the two or more first layers (200) at least partially extends under a first edge of the first die (104a) and wherein a second portion of the two or more first layers (200) at least partially extends under a second edge of the second die (104b);
in particular wherein the first portion of the two or more first layers (200) extending under the first edge of the first die (104a) does not extend past a first center of the first die (104a) and wherein the second portion of the two or more first layers (200) extending under the second edge of the second die (104b) does not extend past a second center of the second die (104b).

9. The substrate (102) of any of claims 1 to 8, wherein the two or more first layers (200) comprise a first number (N) of conducting layers and a second number (N+1) of dielectric layers, wherein the dielectric layers alternate with the conducting layers.

10. The substrate (102) of claim 9, comprising at least one of the following features:
(i) wherein a second thickness of the second layer (112) is about equal to the first number of the conducting layers multiplied by a third thickness of the conducting layers plus the second number of the dielectric layers multiplied by a fourth thickness of the dielectric layers;
(ii) wherein a third thickness of a conducting layer is between about a second thickness of the second layer (112) divided by sixteen and about the second thickness of the second layer (112) divided by eight, and wherein a fourth thickness of a dielectric layer is between about the second thickness of the second layer (112) multiplied by five and divided by thirty-two and about the second thickness of the second layer (112) multiplied by thirteen and divided by sixty-four.;
(iii) wherein the two or more first layers (200) comprise at least three conducting layers and at least four dielectric layers, wherein the at least three conducting layers comprise a return ground layer and two routing layers.

11. A method of manufacturing a substrate (102) of a semiconductor device (100), the method comprising:
forming a portion of a first substrate;
forming two or more first layers (200) on a surface of the portion of the first substrate, wherein the two or more first layers (200) comprise a connector (202) configured to couple a first die (104a) to a second die (104b); and
forming a second layer (112) on the portion of the first substrate and surrounding the two or more first layers (200), wherein a first length (L1) of the two or more first layers (200) is less than a second length (L2) of the second layer (112).

12. The method of claim 11, wherein forming the two or more first layers (200) comprises:
forming a first dielectric layer (212a) on the surface of the portion of the first substrate;
forming a conducting layer (210a) on the first dielectric layer (212a); and
forming a second dielectric layer (212b) on the conducting layer (210a);
in particular wherein forming the first dielectric layer (212a) on the surface of the portion of the first substrate further comprises forming a first via (218a) in the first dielectric layer (212a), wherein forming the conducting layer (210a) on the first dielectric layer (212a) comprises forming an interconnect (214a) and coupling the interconnect (214a) to the first via (218a), and wherein forming the second dielectric layer (212b) comprises forming a second via (218b) in the first dielectric layer (212a) and coupling the second via (218b) to the interconnect (214a).

13. The method of any of claims 11 to 12, comprising at least one of the following features:
(i) forming two or more first layers (200) on a surface of the portion of the first substrate comprises forming the two or more first layers (200) only in one or more die-to-die link areas of the substrate;
(ii) further comprising:
coupling a first die (104a) to the connector (202); and
coupling a second die (104b) to the connector (202).

14. A substrate (102) comprising:
two or more first layers (200) comprising a connector (202) configured to couple a first die (104a) to a second die (104b); and
a second layer (112), wherein the two or more first layers (200) are at least partially surrounded by the second layer (112), and wherein a first length (L1) of the two or more first layers (200) is less than a second length (L2) of the second layer (112).

15. The substrate (102) of claim 14, wherein a first thickness of the two or more first layers (200) is about a same thickness as a second thickness of the second layer (112).
